# EUROPEAN PATENT SPECIFICATION

(11) **EP 0 910 868 B1**
(45) Date of publication and mention of the grant of the patent: **13.10.2004**
(21) Application number: 97929595.3
(22) Date of filing: 08.07.1997
(51) Int. Cl.: H01L 21/00

(54) **METHOD AND APPARATUS FOR CONTACTLESS TREATMENT OF A SEMICONDUCTOR SUBSTRATE IN WAFER FORM**
VERFAHREN UND EINRICHTUNG ZUR BERÜHRUNGSLOSE BEHANDLUNG EINES SCHEIBEN FÖRMIGES HALBLEITERSUBSTRATS
PROCEDE ET DISPOSITIF DE TRAITEMENT SANS CONTACT D'UN SUBSTRAT SEMI-CONDUCTEUR SOUS FORME DE PLAQUETTE

(30) Priority: 08.07.1996 NL 1003538
(43) Date of publication of application: 28.04.1999
(73) Proprietor: ASM International N.V., 3723 BG Bilthoven (NL)
(72) Inventor: GRANNEMAN, Ernst, Hendrik, August, NL-1217 AD Hilversum (NL); HUUSSEN, Frank, NL-3721 PE Bilthoven (NL)
(74) Representative: van Westenbrugge, Andries
(86) International application number: PCT/NL1997/000398
(87) International publication number: WO 1998/001890

(56) References cited:
- NL-A- 8 103 979
- NL-A- 8 200 753
- NL-A- 8 203 318
- NL-A- 8 402 410
- US-A- 4 622 918
- US-A- 4 958 061
- PATENT ABSTRACTS OF JAPAN vol. 9, no. 85 (E-308), 13 April 1985 & JP 59 215718 A (KOKUSAI DENKI KK), 5 December 1984,
- The Oxford Encyclopedic English Dictionary, Clarendon Press, Oxford, 1991, page 1577

## Description

The present invention relates to a method for contactless treatment of a semiconductor wafer substrate, comprising placing said substrate in an apparatus which at least partially encloses said substrate and applying two gas streams, in opposing directions, from first and second side sections located opposite one another, to the two opposing sides of the semiconductor substrate.

A method of this type is disclosed in Netherlands Laid Open Application 8402410, in which, furthermore, reference is made to Netherlands Laid Open Applications 8103979, 8200753 and 8203318.

From these publications it is known to position a wafer such that it is floating between the two side sections. If the gas flow is suitably chosen, it has been found that a highly accurate definition of the position of the wafer with respect to the side sections is possible and this position is relatively fixed, that is to say little variation occurs in the position of the wafer with respect to the side sections. In the patent publications concerned it is described that the wafer is subjected to a wet treatment and is then possibly dried. For the purposes of drying, the gas which holds the wafer in place is heated to about 100 °C and is moved over the surface of the wafer, as a result of which the moisture present is automatically removed.

Heating is frequently necessary when treating semiconductor substrates. Heating can involve annealing or raising the temperature to make deposition or other processes possible. In the prior art wafers are to this end placed in furnaces and then heated. Although this method is adequate, it has at least two disadvantages. Firstly, a method of this type is never contactless, that is to say certain points of the wafer must always be supported. Secondly, it takes a relatively long time to heat a wafer. This is due not so much to the thermal capacity of the wafer itself as to the thermal capacity of the furnace in which the wafers are placed.

In order to solve this problem single wafer systems have been disclosed with which rapid heating was achieved with the aid of high power lamps (50-80 kW). Such a method is particularly expensive and difficult to control.

US patent 4 622 918 discloses an apparatus wherein a wafer is fed through between a number of columns located some distance apart. Sets of columns located opposite one another, between which the wafer moves, are likewise some distance apart. In the gap between the sets of columns, heating is effected by means of a lamp some distance away. This apparatus also has the drawback of relatively slow energy-consuming heating by means of lamps.

It has been found that only limited heating can take place effectively by heating the gases, as is described in the abovementioned Netherlands applications.

The aim of the present invention is to provide a method with which contactless heating of semiconductor substrates to relatively high temperature within a relatively short time is possible.

This aim is achieved with a method according to claim 1 and an apparatus according to claim 10.

Surprisingly, it has been found that if the spacing between the side sections, or between side section and wafer, is set to be relatively small, particularly rapid heat transfer can take place. It is possible to achieve heating to far above 1000 °C within a few seconds. Because with this arrangement the wafer, in principle, does not have to be supported, but is held accurately and definitively in its place by the gas streams, the wafer will also not be subjected to stresses generated by local temperature differences and distortion will be prevented as far as possible. Incidentally, it is pointed out that if a slight degree of distortion does take place, the stabilising effect of the gas streams in opposing directions is such that the wafer is pressed straight in a 'gentle' manner without damage.

Furthermore, it has been found that, relatively, particularly little energy is needed to achieve such heating of wafers. It will be understood that the method described above is outstandingly suitable for processes in which wafers are treated one by one ('single wafer processing'). However, it is also possible to treat large numbers of wafers one after the other or parallel to one another in the manner described above.

Introduction of the wafer into the enclosing apparatus described above is effected by moving the side sections apart. The wafer is placed between the side sections when the latter have been moved apart. Supporting means can optionally be present to fix the wafer in such a position. The side sections then move towards one another and the function of the supporting means is taken over by the gas stream moving out of the side sections concerned. As a result, the wafer moves away from the supporting means.

Apart from heating the semiconductor substrate in this way it is also possible to carry out treatments on the substrate, such as oxidation, etching or the deposition of layers. To this end it is possible to mix a gaseous medium with the gas which holds the wafer in its place. Of course, it is also possible to position the wafer using process gas only. This is in contrast to what is described and suggested in the abovementioned Netherlands Applications, where only wet treatment of the related substrate takes place. This process gas can be supplied, uniformly distributed, from one of the side sections, such that a uniform distribution over the related wafer surface takes place.

One of the problems encountered in the prior art when supplying process gas at elevated temperature and more particularly when depositing layers is that the apparatus used to supply the process gas becomes contaminated by deposition of the material concerned from the process gas. This means that apparatuss of this type have to be cleaned regularly and that major problems arise with regard to clogging.

With the method according to the invention it is possible to prevent these problems. This is because, according to a further embodiment of this method, a temperature difference is applied over the wafer. One of the side sections is heated to a relatively high temperature, whilst the other of the side sections is heated to a relatively low temperature. It has been found that, as a result of the thermal behaviour of the enclosing apparatus, the wafer will assume a temperature which is dependent on the position of the wafer with respect to the two heated side sections. If the two side sections are equidistant from the wafer and the same gas is present on both sides, the temperature will fairly accurately be the average of the values of the temperatures of each of the side sections.

If, by controlling one or both gas streams, the wafer is not located centrally between the two side sections, the temperature will change correspondingly.

If different types of gas are used, that is to say gases having different thermal conduction properties, a change in temperature will likewise take place. For example, when argon is used on one side and hydrogen is used on the other side it has been found that transfer between the relevant side section and the wafer is ten times better on the side where hydrogen is supplied.

Consequently, by means of a suitable choice of the temperatures concerned, it is possible to provide the side section from which the process gas is emitted with a temperature such that no deposition takes place on such side section, whilst the wafer is at a temperature which is so much higher that deposition does take place on such wafer.

It has been found that the rate of deposition of, for example, polysilicon from silane on a substrate is lower by a factor of 350 at 700 K and a partial pressure of 0.4 Torr (1 Torr = 133 Pa) than at 900 K. This means that by controlling the temperature, deposition is negligible on the side section from which the process gas is supplied and which is at low temperature.

With this arrangement it is possible, in the starting position, to place the wafer with the 'device side' of the wafer towards the side section which is at the lowest temperature, through which side section the process gas is subsequently supplied. As a result of supplying the reactive gases, the wafer is moved towards the side section at the higher temperature and, on assuming the higher temperature, deposition accordingly takes place. The reverse set-up is also possible. That is to say, the side section from which the gas emanates is at a higher temperature than the opposite side section. In this case the 'device side' of the wafer faces the side section which is at the lower temperature and the Bernoulli principle can be used by allowing the correct gas stream to flow against the top of the wafer. With this arrangement a reduced pressure is created beneath the wafer, which reduced pressure ensures that the wafer will float (in a stable manner) beneath the top side section. The hot (bottom) side section is then raised until the process situation is achieved.

It has been found that appreciable temperature differences between the related side section and the wafer are possible using the construction described above. A value of at least 150 °C and more particularly 200 °C may be mentioned by way of example.

With the method according to the invention, these values can be set very accurately. After all, it has been found that these values are mainly dependent on the position of the wafer in the enclosing apparatus. As already indicated above, the position of the wafer in the tunnel-like apparatus is accurately related to the quantity and type of gas supplied from the related side sections.

In the apparatus according to the invention at least one of the side sections is provided with heating means for heating said section(s) to above 250 °C. Surprisingly, it has been found that relatively little power is needed to achieve a relatively high temperature. It is in particular the thermal capacity of the side section concerned which is of importance for the stability of the process. The thermal capacity must be as high as possible.

The related side section is provided with a number of spaced gas feed channels in order to provide uniform metering of the gas and more particularly process gas.

In a simple embodiment which is particularly suitable for deposition purposes, a very large number of injection points must be present. A construction of this type can, for example, be achieved by providing porous plates.

The invention will be explained below with reference to an illustrative embodiment shown in the drawing. In the drawing:
Fig. 1 shows, diagrammatically, an apparatus according to the invention in the position in which the semiconductor substrate is introduced;
Fig. 2 shows part of the apparatus after introduction of the semiconductor substrate; and
Fig. 3 shows a graph in which the rate of heating of the semiconductor substrate is shown for the apparatus according to Figs 1 and 2.

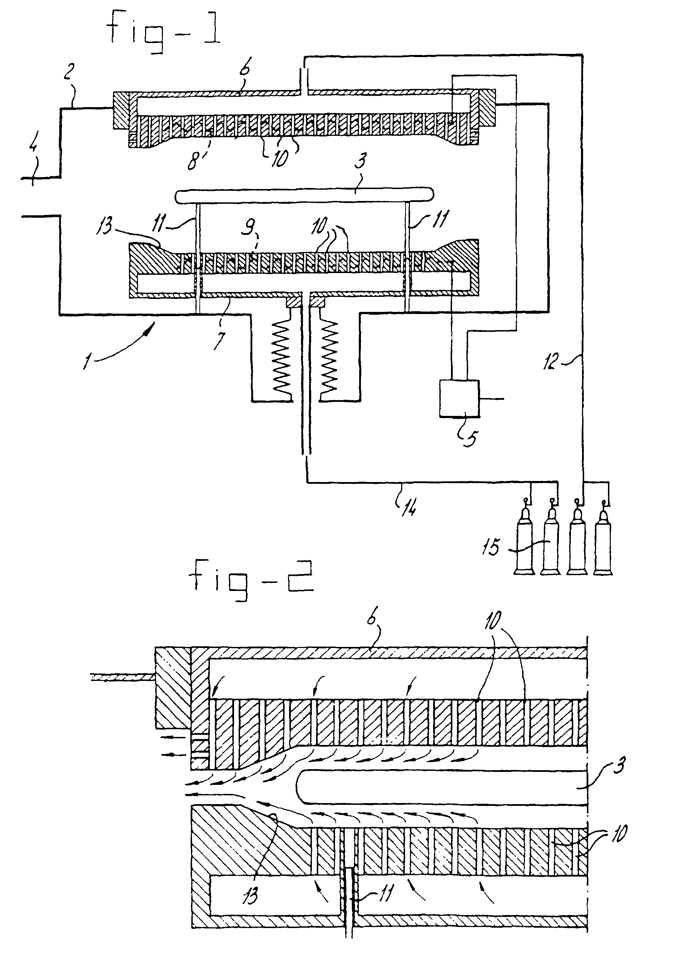

In Fig. 1 the apparatus according to the invention is indicated in its entirety by 1. This apparatus is provided with an inlet 4, which can be connected, in a manner not shown in more detail, to a 'load lock' or a cluster system for further treatment of semiconductor substrates.

The actual apparatus according to the invention, consisting of the first and second side sections 6 and 7, respectively, is accommodated in a pressure vessel 2 for carrying out a process in a specific environment or under elevated or reduced pressure.

The first side section 6 is joined rigidly to the pressure vessel 2. A heating coil 8, which is connected to a control 5, is mounted inside said first side section. A gas supply line 12 is also present, which gas supply line is connected to the gas feeds 10 which consist of a number of uniformly distributed passages.

It must be understood that in practice a very much larger number of passages will generally be used, which passages are each very much smaller than is shown. For the sake of clarity, the various features have been shown in exaggerated form in the drawing.

Side section 6 is provided at the ends with centring chamfers 13. As can be seen from Fig. 2, these serve for enclosure of a semiconductor substrate or wafer 3.

Second side section 7 is constructed correspondingly. Supporting pins 11 for supporting the semiconductor substrate extend through the second side section 7.

As can be seen from Fig. 2, the various features are so dimensioned that when the two side sections are in the closed position, the semiconductor substrate 3 is no longer supported by the supporting pins 11 but by the gas streams which move towards the semiconductor substrate 3 from both side sections.

It will be understood that the various features are dependent on the application concerned.

Gas passages 10 in the second side section 7 are connected to a gas supply line 14, which is connected to a source 15.

The apparatus described above functions as follows:

Starting from the situation shown in Fig. 1 , the wafer 3 is placed on the supporting pins 11, as is also shown in Fig. 2. The second side section 7 is then moved up and the situation as shown in Fig. 2 is obtained. The wafer 3 is accurately positioned in the centre between the two side sections 6 and 7 by the gas streams issuing from the passages 10 in said two side sections. Deviation in the position is possible by means of adjusting the gas flow.

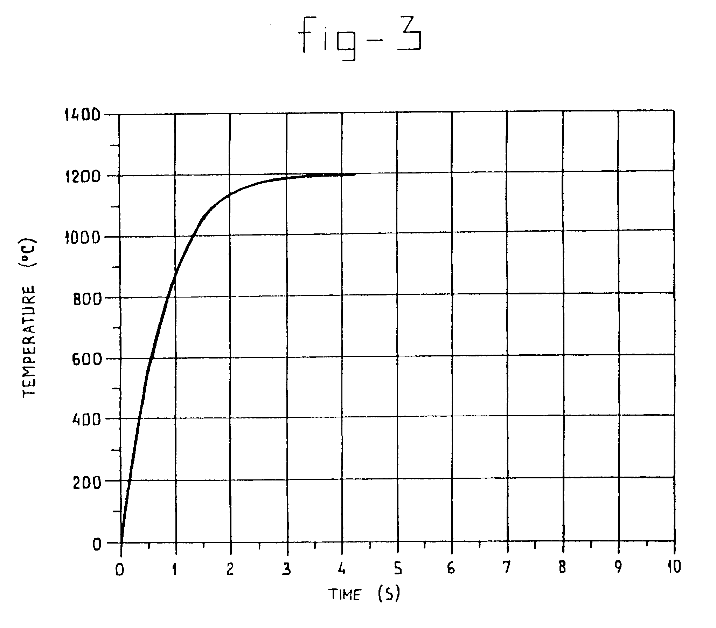

The side sections are heated by operation of the heating elements 8 and 9 and it has been found that this heat is transferred to the wafer with negligible loss. In practice, it has been found that almost immediately after it has entered the gap between the side sections 6 and 7 the wafer assumes the temperature thereof. This is in a situation where the temperature of the side sections 6 and 7 is identical. Such an example is shown in Fig. 3. In this case both side sections have been heated to a temperature of approximately 1200 °C. It has been found that wafer 3 has the same temperature within four seconds. Because wafer 3 is not supported and is heated uniformly, no thermal stresses will be produced, as a result of which there is no question of distortion.

At such an elevated temperature it is possible to anneal the wafer or to carry out an oxidising or reducing treatment. In the latter case the relevant gases are supplied as process gases through the passages 10.

Apart from furnaces, radiation lamps are also used in the prior art, the wafer being positioned on a bearing surface. Apart from the abovementioned risk of distortion as a result of non-uniform heating caused by removal of heat to the support point, the heating rate is relatively slow. Values of 5-10°/s are not uncommon if the wafer is on a susceptor. In all other cases, values of 50-100°/s have been found.

In certain cases it is, however, desirable to subject the wafer to a deposition treatment. The case in which a process gas, from which material has to deposit on the wafer, is present in source 15 is chosen as an example here. To prevent the passages 10 in the second side section 7 from becoming clogged by premature deposition of material from the process gas concerned, it is proposed to bring the first side section 6 to a relatively high temperature and the second side section 7 to a relatively low temperature with the aid of control 5.

If, for example, for polysilicon the deposition temperature of material from the silane gas issuing from source 15 is 625 °C (900 K), it is proposed to heat the first side section 6 to a temperature of 1100 K and the second side section 7 to a temperature of approximately 700 K. At 700 K virtually no deposition of material from the gas will take place, so that the passages 10 concerned will not clog. However, the wafer is found accurately to assume a temperature which is midway between that of the first side section 6 and that of the second side section 7, this being the desired temperature of 900 K. As a result of the flow of the gases shown (Fig. 2), it is largely precluded that gas issuing from the second side section 7 will enter the -first hot side section 6 and deposit there. In any event it has not been found that passages 10 in the first side section 6 clog.

In the case of a deposition treatment of this type it is not uncommon first to supply an inert gas and then to supply the treatment gas. This is represented symbolically by showing a number of gas bottles at 15 and the quantity or mixing ratio or type of gas supplied to the line 12 or 14 can be controlled by means of control means, which are not shown in more detail.

Close to the end sections of the side sections, the upper side section is provided with a large number of gas passages, whilst this is not the case for side section 7. In this way an accurately controlled gas purge flowing radially outwards can be provided and deposition on section 6 prevented.

If the side section 7 is at a lower temperature, it is not necessary to use the pins described above. The wafer can be placed directly on side section 7. In such a case it is not even desirable to use pins, because in a set-up of this type the 'device side' faces downwards.

It has been found that a very small amount of gas is needed with the method described above. An amount of between 0.1 and 25 litres per second under standard conditions under a pressure in the vessel which is between 1 Torr and 1 atm (1 atm = 101 325 Pa) may be mentioned here as an example. The various aspects are wholly dependent on the process conditions.

When the treatment is complete, the side sections can be moved away from one another again and the wafer removed. Cooling takes place equally as rapidly as heating without any damage over the entire extent of the wafer.

It must be understood that the relative sizes shown in the figures are incorrect and have been introduced for the sake of clarity. Thus, the diameter of a typical wafer is approximately 6-8 inch (1 inch = 2.54 cm) and the thickness approximately 0.7 mm. The distance between a wafer and the surface of the relevant side sections from which gases issue is 1 mm or less, for example a few tenths of millimetres.

It is possible to impose a rotary movement on the wafer, as a result of which an even more uniform treatment is provided.

Such a rotation can, for example, be achieved by positioning one or more of the channels 10 at an angle with respect to the vertical, as a result of which a spiral gas flow is generated.

These and further variants are obvious to a person skilled in the art after reading the above description and fall within the scope of the invention as defined in the appended claims.

## Claims

1. Method for contactless treatment of a semiconductor wafer substrate (3) comprising placing said substrate in an apparatus which at least partially encloses said substrate and applying two gas streams, in opposing directions from first and second side sections (6,7) located opposite one another, to the two opposing sides of the semiconductor substrate to position said substrate, wherein the spacing between each of said first and second side sections and the semiconductor substrate is set to at most 1 mm, **characterized in that** at least one of said side sections is heated to a temperature higher than 200°C, and said side sections are movable with respect to one another, the semiconductor substrate is introduced at a low temperature between the two side sections positioned a relatively large distance apart, after which the side sections are moved towards one another to support the substrate by the gas streams and that the gas streams are supplied such that the gas is uniformly distributed over the surface of the semiconductor substrate to be treated so as to heat up the substrate.

2. Method according to claim 1, wherein in the starting position the substrate is supported by mechanical auxiliary means (11).

3. Method according to one of the preceding claims, wherein the substrate is subjected to a rotary movement.

4. Method according to one of the preceding claims, wherein at least one of said gas streams comprises a process gas.

5. Method according to claim 4, wherein the first side section of the enclosing apparatus is brought to a first temperature and the second side section, which is opposite said first side section, is brought to a second lower temperature and in that the process gas is supplied from the second side section.

6. Method according to claim 5, wherein the temperature difference between the wafer and one of said side sections is set to a least 150°C.

7. Method according to claim 6, wherein the temperature difference between the wafer and one of said side sections is set to at least 200°C.

8. Method according to one of the claims 5-7, wherein the substrate is moved from the mid point between the side sections by controlling the flow of gases.

9. Method according to one of claims 5-8, wherein gases having different heat transfer are used from the first side section and from the second side section.

10. Apparatus (1) for contactless treatment of a semiconductor wafer substrate (3), comprising an enclosing part provided with at least first and second side sections (6,7) for accommodating a semiconductor substrate (3) between them, and having passages (10) to supply gas for positioning said wafer between said side sections **characterised in that** at least one of said side sections is provided with heating means (8, 9) for heating said section(s) to above 250°C, and **in that** said gas supply passages are provided such that a uniform distribution of a gas over the surface of the semiconductor substrate to be treated may be obtained, and **in that** said side sections are movable with respect to one another while heated, between a moved apart position to facilitate loading of a semiconductor substrate between said side sections and a closed position wherein a semiconductor substrate is supported by the gas streams and spaced 1 mm or less from said side sections.

11. Apparatus according to claim 10, wherein support means (11) are present which can be used to support the substrate when said side sections are positioned a relatively large distance apart.

12. Apparatus according to claim 12, wherein said gas supply passages (10) are provided in the form of a porous plate.

## Patentansprüche

1. Verfahren zur berührungslosen Behandlung eines Halbleiter-Wafersubstrats (3), welches umfasst, das Substrat in einer Einrichtung anzuordnen, welche zumindest teilweise das Substrat umschließt, und zwei Gasströme einwirken zu lassen, in entgegengesetzten Richtungen von ersten und zweiten Seitenabschnitten (6, 7), die entgegensetzt zueinander angeordnet sind, auf die beiden entgegengesetzten Seiten des Halbleitersubstrats, um diese zu positionieren, wobei der Abstand zwischen jeweils dem ersten und zweiten Seitenabschnitt und dem Halbleitersubstrat auf höchstens 1 mm eingestellt wird, **dadurch gekennzeichnet, dass** zumindest einer der Seitenabschnitte auf eine Temperatur erwärmt wird, die höher als 200 °C ist, und die Seitenabschnitte in Bezug aufeinander beweglich sind, das Halbleitersubstrat bei einer niedrigen Temperatur zwischen die beiden Seitenabschnitte eingeführt wird, die eine relativ große Entfernung voneinander beabstandet sind, wonach die Seitenabschnitte zueinander hin bewegt werden, um das Substrat durch die Gasströme zu heizen, und die Gasströme so zugeführt werden, dass Gas gleichmäßig über die Oberfläche des zu behandelnden Halbleitersubstrats verteilt wird, um so das Substrat zu erwärmen.

2. Verfahren nach Anspruch 1, bei welchem in der Startposition das Substrat durch eine mechanische Hilfsvorrichtung (11) gehaltert wird.

3. Verfahren nach einem der voranstehenden Ansprüche, bei welchem mit dem Substrat eine Drehbewegung durchgeführt wird.

4. Verfahren nach einem der voranstehenden Ansprüche, bei welchem zumindest einer der Gasströme ein Prozessgas aufweist.

5. Verfahren nach Anspruch 4, bei welchem der erste Seitenabschnitt der umschließenden Einrichtung auf eine erste Temperatur gebracht wird, und der zweite Seitenabschnitt, welcher entgegengesetzt zum ersten Seitenabschnitt ist, auf eine zweite, niedrigere Temperatur gebracht wird, und das Prozessgas von dem zweiten Seitenabschnitt zugeführt wird.

6. Verfahren nach Anspruch 5, bei welchem die Temperaturdifferenz zwischen dem Wafer und einem der Seitenabschnitte auf zumindest 150 °C eingestellt ist.

7. Verfahren nach Anspruch 6, bei welchem die Temperaturdifferenz zwischen dem Wafer einem der Seitenabschnitte auf zumindest 200 °C eingestellt ist.

8. Verfahren nach einem der Ansprüche 5 bis 7, bei welchem das Substrat von dem Mittelpunkt zwischen den Seitenabschnitten durch Steuern des Flusses von Gasen bewegt wird.

9. Verfahren nach einem der Ansprüche 5 bis 8, bei welchem Gase mit unterschiedlicher Wärmeübertragung von dem ersten Seitenabschnitt und von dem zweiten Seitenabschnitt eingesetzt werden.

10. Einrichtung (1) zur berührungslosen Behandlung eines Halbleiter-Wafersubstrats (3), die ein umschließendes Teil aufweist, das mit zumindest einem ersten und einem zweiten Seitenabschnitt (6, 7) zum Aufnehmen eines Halbleitersubstrats (3) zwischen sich versehen ist, und Kanäle (10) für die Zufuhr von Gas zum Positionieren des Wafers zwischen den Seitenabschnitten aufweist, **dadurch gekennzeichnet, dass** zumindest einer der Seitenabschnitte mit einer Heizvorrichtung (8, 9) zum Erwärmen des Abschnitts bzw. der Abschnitte auf oberhalb von 250 °C versehen ist, und die Gaszufuhrkanäle so vorgesehen sind, dass eine gleichmäßige Verteilung eines Gases über die Oberfläche des zu behandelnden Halbleitersubstrats erhalten werden kann, und die Seitenabschnitte in Bezug aufeinander bewegbar sind, während sie erwärmt werden, zwischen einer wegbewegten Position zum Erleichtern des Ladens eines Halbleitersubstrats zwischen den Seitenabschnitten und einer geschlossenen Position, bei welcher ein Halbleitersubstrat durch die Gasströme gehaltert wird, und die um einen Millimeter oder weniger von den Seitenabschnitten beabstandet ist.

11. Einrichtung nach Anspruch 10, bei welcher Halterungsvorrichtungen (11) vorgesehen sind, die dazu eingesetzt werden können, das Substrat zu haltern, wenn die Seitenabschnitte eine relativ große Entfernung voneinander beabstandet sind.

12. Einrichtung nach Anspruch 11, bei welcher die Gaszufuhrkanäle (10) in Form einer porösen Platte ausgebildet sind.

## Revendications

1. Procédé de traitement sans contact d'un substrat semi-conducteur en plaquette (3) comprenant le placement dudit substrat dans un appareil qui entoure au moins partiellement ledit substrat et l'application de deux jets de gaz dans des directions opposées, depuis des première et seconde sections latérales (6, 7) situées à l'opposé l'une de l'autre, sur les deux côtés opposés du substrat semi-conducteur pour positionner ledit substrat, dans lequel l'espacement entre chacune desdites première et seconde sections latérales et le substrat semi-conducteur est établi au maximum à 1 mm, **caractérisé en ce que** au moins l'une desdites sections latérales est chauffée à une température supérieure à 200°C, et lesdites sections latérales peuvent se déplacer l'une par rapport à l'autre, le substrat semi-conducteur est introduit à une faible température entre les deux sections latérales positionnées à une distance relativement grande l'une de l'autre, après quoi les sections latérales sont déplacées en direction l'une de l'autre pour que les jets de gaz supportent le substrat et les jets de gaz sont appliqués de telle sorte que le gaz est distribué uniformément sur la surface du substrat semi-conducteur à traiter de façon à chauffer le substrat.

2. Procédé selon la revendication 1, dans lequel dans la position de départ, le substrat est supporté par des moyens mécaniques auxiliaires (11).

3. Procédé selon l'une des revendications précédentes, dans lequel le substrat est soumis à un mouvement de rotation.

4. Procédé selon l'une des revendications précédentes, dans lequel au moins l'un desdits jets de gaz comprend un gaz de traitement.

5. Procédé selon la revendication 4, dans lequel la première section latérale de l'appareil d'enceinte est amenée à une première température et la seconde section latérale, qui est opposée à ladite première section latérale, est amenée à une seconde température plus basse, et dans lequel le gaz de traitement est appliqué depuis la seconde section latérale.

6. Procédé selon la revendication 5, dans lequel la différence de température entre la plaquette et l'une desdites sections latérales est établie à au moins 150°C.

7. Procédé selon la revendication 6, dans lequel la différence de température entre la plaquette et l'une desdites sections latérales est établie à au moins 200°C.

8. Procédé selon l'une des revendications 5 à 7, dans lequel le substrat est déplacé depuis le point au centre entre les sections latérales en contrôlant l'écoulement des gaz.

9. Procédé selon l'une des revendications 5 à 8, dans lequel des gaz ayant différents transferts de chaleur sont utilisés depuis la première section latérale et depuis la seconde section latérale.

10. Appareil (1) pour le traitement sans contact d'un substrat semi-conducteur en plaquette (3) comprenant une partie d'enceinte munie d'au moins des première et seconde sections latérales (6, 7) pour loger un substrat semi-conducteur (3) entre elles, et ayant des passages (10) pour appliquer du gaz pour positionner ladite plaquette entre lesdites sections latérales, **caractérisé en ce que** au moins l'une desdites sections latérales est munie de moyens de chauffage (8, 9) pour chauffer ladite ou lesdites section(s) jusqu'à plus de 250°C, et **en ce que** lesdits passages d'alimentation en gaz sont prévus de telle sorte qu'une distribution uniforme d'un gaz sur la surface du substrat semi-conducteur à traiter puisse être obtenue, et **en ce que** lesdites sections latérales peuvent se déplacer l'une par rapport à l'autre tout en étant chauffées, entre une position séparée pour faciliter le chargement d'un substrat semi-conducteur entre lesdites sections latérales, et une position fermée dans laquelle un substrat semi-conducteur est supporté par les jets de gaz et espacé de 1 mm ou moins desdites sections latérales.

11. Appareil selon la revendication 10, dans lequel des moyens de support (11) sont présents, lesquels peuvent être utilisés pour supporter le substrat lorsque lesdites sections latérales sont positionnées à une distance relativement grande l'une de l'autre.

12. Appareil selon la revendication 11, dans lequel lesdits passages d'alimentation en gaz (10) sont prévus sous la forme d'une plaque poreuse.
